# EUROPÄISCHE PATENTSCHRIFT

(11) **EP 0 897 189 B1**
(45) Veröffentlichungstag und Bekanntmachung des Hinweises auf die Patenterteilung: **16.10.2002**
(21) Anmeldenummer: 98114847.1
(22) Anmeldetag: 07.08.1998
(51) Int. Cl.: H01J 37/34, C23C 14/34

(54) **Hochdruck-Magnetron-Kathode sowie eine solche enthaltende Vorrichtung**
High pressure magnetron cathode and device comprising same
Cathode magnétron sous haute pression et dispositif comprenant une telle cathode

(30) Priorität: 11.08.1997 DE 19734633
(43) Veröffentlichungstag der Anmeldung: 17.02.1999
(73) Patentinhaber: Forschungszentrum Jülich GmbH, 52425 Jülich (DE)
(72) Erfinder: Wördenweber, Roger, Dr., 52382 Niederzier (DE); Ockenfuss, Georg, Dr., 52066 Aachen (DE); Schneider, Jens, Dr., 52428 Jülich (DE); Klein, Wilfried, 52428 Jülich (DE)

(56) Entgegenhaltungen:
- EP-A- 0 297 779
- US-A- 4 169 031
- US-A- 5 470 451
- LING S H ET AL: "HIGH PRESSURE MAGNETRON SPUTTER GUN" JOURNAL OF VACUUM SCIENCE AND TECHNOLOGY: PART A,US,AMERICAN INSTITUTE OF PHYSICS. NEW YORK, Bd. 10, Nr. 3, 1. Mai 1992 (1992-05-01), Seiten 573-575, XP000277990 ISSN: 0734-2101

## Beschreibung

Die Erfindung betrifft eine Hochdruck-Magnetron-Kathode gemäß dem Oberbegriff des Anspruchs 1. Desweiteren betrifft die Erfindung eine Vorrichtung mit einer solchen Kathode gemäß dem Oberbegriff des Nebenanspruchs.

Als Stand der Technik ist es bekannt, die Abscheidung von Materialien bestehend aus einzelnen Elementen (Metallen oder dergleichen), Legierungen oder reaktiv aus Einzel- oder Mehrkomponententargets und einem reaktiven Gas (zum Beispiel N₂ oder O₂) mittels des technisch etablierten Kathoden- bzw. magnetgestützten (Magnetron) Sputterns üblicherweise bei Drücken von unterhalb eines Wertes von 1*10⁻² mBar stattfinden zu lassen. Bei diesen Prozessdrücken sind zum einen die freien Weglängen vergleichsweise groß, so daß die abgestäubten Teilchen je nach Target-Substrat-Abstand nahezu ohne Wechselwirkung miteinander auf dem Substrat auftreten. Dadurch ist im Gegensatz zu anderen Depositionsverfahren die Energie dieser Teilchen üblicherweise relativ hoch, was u.a. zur Erzeugung hochwertiger, dichter Schichten mit hoher Haftung und Härte eingesetzt wird. Dies ist z.B. ein entscheidender Unterschied zu den Aufdampfprozessen, bei denen die Teilchen eine wesentlich geringere Energie beim Abdampfen erhalten.

Aus EP-A-0 297 779 ist eine Magnetron-Kathode mit einer Blende am Rand eines kathodenseitigen Dunkelraums bekannt. Eine Gasdusche in Form einer Gasleitung mündet dabei unter die Anode.
US-A-4 169 031 offenbart eine Dunkelraumblende, die schwebend oder mit bias-Potential versorgt angeordnet ist.
Aus Ling et al. (Ling S.H. et al. High pressure magnetron sputter gun. Journal of vacuum science and technology, Part A, US, American Institute of physics. New York, Bd. 10, Nr. 3, 1. Mai 1992 (1992-05-01), Seiten 573-575, XP000277990 ISSN:0734-2101) ist bekannt, hoch T_{c} supraleitendes Material zu zerstäuben.

Neuerdings sind Anwendungen der Dünnschichttechnologie bekannt, bei denen die Forderung nach geringen Teilchenenergien der am Substrat auftreffenden Teilchen gestellt wird. Typische Prozesse sind z.B. die Herstellung der komplexen Hochtemperatursupraleiter (HTS) oder artverwandter oxydischer Keramiken, als auch empfindlicher organischer Trägermaterialien. Insbesondere existieren Prozesse, bei denen die Energie der Teilchen höher als die beim Aufdampfen und niedriger als die typisch beim Sputtern erreichte Energie genau eingestellt werden muß.

Für all diese Prozesse bietet sich das Sputterverfahren unter Verwendung der sogenannten Thermalisierung an. Hierbei wird der Druck während des Sputterns in geeigneter Weise erhöht, so daß durch Verminderung der freien Weglänge die abgestäubten Teilchen entsprechend den Anforderungen durch Teilchenkollision abgebremst werden und auf diese Weise mit reduzierter Energie am Substrat ankommen.

Nachteilig bei der bekannten Magnetron-Anordnung mit Kathode ist jedoch, daß der erhöhte Druck zu einer Veränderung des Plasmas führt. So ist der kathodenseitige Dunkelraum wesentlich stärker auf die Kathodenoberfläche reduziert. Die Verwendung von Standardblenden, die üblicherweise zur Ausblendung des Ionenbombardements im Randbereich des Targets eingesetzt werden, würde zu einem unerwünschten Sputtern zwischen Kathode und Blende führen. Die Notwendigkeit solcher Blenden begründet sich aus den folgenden Punkten:
(i) Für die meisten Sputterdepositionen wird ein anormaler Sputterbereich gewählt (siehe z.B. Deposition von HTS-Material). Das Erreichen dieses Sputtermodus ist im Hochdruckbereich mit sehr hohen Energien verbunden, die dann schnell zu Überschlägen führen können. Insbesondere beim Deponieren von HTS-Material führt dies direkt zur Zerstörung des Targets.
(ii) Der hohe Druck beim Sputtern dient der Thermalisierung der Teilchen. Die Erhöhung des Druckes führt jedoch gleichzeitig zur Veränderung des Sputterprofils. D.h. die Flächenhomogenität der Depositionsrate nimmt ab, je weiter der Druck erhöht wird.

Aufgabe der Erfindung ist es eine Hochdruck-Magnetron-Kathode zu schaffen, sowie eine solche Kathode enthaltende Vorrichtung bereitzustellen, mit der die Strahlenbelastung am Target verhindert wird.

Die Aufgabe wird gelöst durch eine Hochdruck-Magnetron-Kathode gemäß der Gesamtheit der Merkmale nach Anspruch 1. Ferner wird die Aufgabe gelöst durch eine

Vorrichtung gemäß der Gesamtheit der Merkmale gemäß Nebenanspruch. Weitere zweckmäßige oder vorteilhafte Ausführungsformen finden sich in den auf einem dieser Ansprüche rückbezogenen Unteransprüchen.

Die erfindungsgemäße Kathode unterscheidet sich von bestehenden Magnetron-Kathoden dadurch, daß sie ein oder mehrere Strahlungsschilder in der Blendenanordnung enthält.

Die Blenden (insbesondere eine Mittelblende) werden im Falle der Abscheidung auf heiße Substrate (zum Beispiel für Hochtemperatursupraleiter bei Temperaturwerten im Bereich oberhalb von 600°C) mit zusätzlichen Strahlungsschildern versehen. Diese verhindern zum einen die Strahlungsbelastung am Target, zum anderen können sie thermisch von der Blende nahezu entkoppelt als Wärmeschilder zur Erhöhung der Temperatur am Heizer dienen.

Auf diese Weise wird erreicht, daß die Temperaturhomogenität am Substrat erhöht, die notwendige Energie am Heizer verringert (längere Lebensdauer der Heizer) und die Targets vor der Bestrahlung geschützt werden.

Bei Verwendung einer Magnetron-Kathode mit einer entsprechend ausgelegten Blendenanordnung arbeitet die Magnetron-Kathode im Hochdruckbereich. Sie ermöglicht eine Art off-axis Sputterdeposition und darüber hinaus schon bei niedrigen Energien ein anormales Sputtern.

Zur Lösung der gestellten Aufgabe wird dem reduzierten kathodenseitigen Dunkelraum der Gasentladung Rechnung getragen, indem der Blendenabstand reduziert wird und maximal der Größe des Dunkelraums normal zur Tagetoberfläche entsprechen darf. Einerseits wird dadurch erreicht, daß Zwischenplasmen zwischen Blenden und Target vermieden werden, zum anderen wird dadurch eine ausreichende Spannung (anormaler Modus) ermöglicht. Der Abstand zwischen Target und Blenden ist dabei druckabhängig. Beispielsweise sollte bei einem Druck von 0,4 mbar der Abstand im Bereich von 0,8 mm bis 1 mm eingestellt werden.

Außerdem kann die erfindungsgemäße Kathode alternativ oder kummulativ mit zwei oder mehreren getrennten Blenden ausgestattet sein:

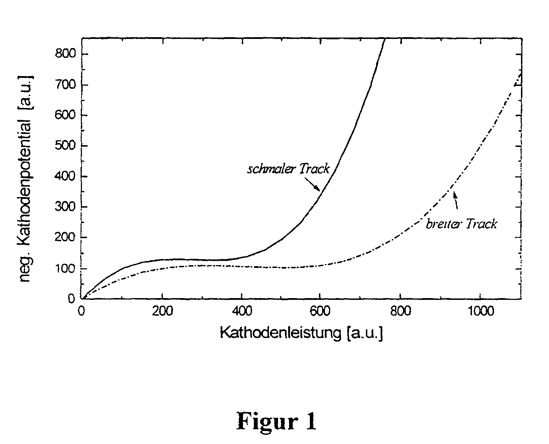

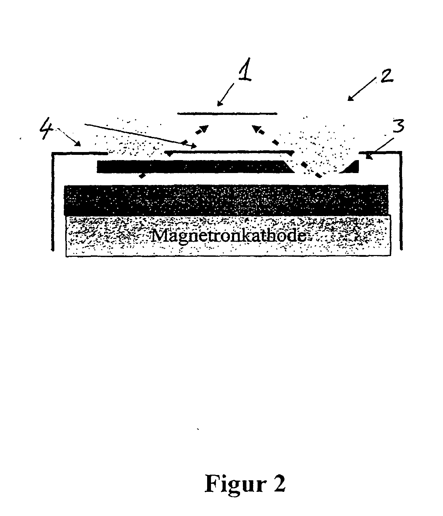

Dabei ist eine erste Blende vorgesehen, mit deren Hilfe die Mitte des Targets (innerhalb des Magnetrontracks) ausgeblendet wird und wobei der offene Trackbereich reduziert wird. Hierdurch läßt sich in Kombination mit der äußeren Blende der Übergang vom normalen in den anormalen Sputtermodus bei wesentlich kleineren Leistungen erzwingen (Fig.1) und es entsteht ein quasi-off-axis Sputtermode (Fig.2), bei dem ein direkter Teilchenbeschuß der aufwachsenden Schicht vermieden wird (die Substratabmessungen sind üblicherweise kleiner als der Magnetrontrackdurchmesser).

Außerdem ist eine weitere, äußere Blende vorgesehen, zur Vermeidung von Verunreinigungen sowie (wie die mittlere Blende) zur Erzeugung ausreichender Spannungen bei geringen Leistungen.

Der innere Radius des freien Tracks (zum Beispiel im Bereich von 1,5 bis 4 cm) ist vorzugsweise kleiner als der Radius des Substrats (quasi-off-axis). Die Breite des offenen Bereiches ist entscheidend für die Strom-Spannungscharakteristik und somit den Übergang zwischen normalem und anormalem Sputterbereich.

Vorteilhaft können zudem sogenannte Gasduschen zur direkten und schnellen Regelung empfindlicher reaktiver Prozesse (z.B. NbN, TiN, YBa₂Cu₃O₇) in die Blendenkonfiguration integriert sein. Diese Mittel können als integrierte Bestandteile der Kathode die Prozessgase oder auch nur Anteile des Prozessgases (z.B. den reaktiven Anteil) direkt dem Target zuführen. Zusätzlich zu der ausserhalb des Magnetrontracks angebrachten Dusche, kann nun auch über die innere Blende eine Gaszufuhr in Form einer Gasdusche realisiert werden. Die Homogenität der Gaszufuhr durch die Gasduschen kann jeweils durch entsprechend Prallbleche erhöht werden.

Besonders vorteilhaft hat sich der Einsatz der Vorrichtung für die Herstellung von YBa₂Cu₃O₇-Schichten erwiesen. Es ergeben sich dabei folgende Vorteile:
- beliebige Sputtermoden wählbar: dc, rf, dc+rf, mf (Mittelfrequenz);
- optimierte Blendenanordnung wahlweise mit Erdpotential, schwebend oder Bias;
- optimierter Substratheizer durch auf den Blenden thermisch entkoppelt montierten Strahlungschildern;
- Gasdusche am Target oder integriert;
- optische Emissionsspektroskopie;
- Langmuirsonden;

Die Erfindung ist im weiteren an Hand der Figur und Ausführungsbeispiel näher erläutert. Es zeigt:
- Fig. 1:: schematische Darstellung des Überganges vom normalen Sputterbereich zum annormalen Sputtermodus für die erfindungsgemäße Kathode;
- Fig. 2:: Magnetron-Kathode-Anordnung mit Blendenanordnung;
- Fig. 3:: erfindungsgemäße Magnetron-Kathode.

### Ausführungsbeispiel

In der Figur 1 ist eine schematische Darstellung des Überganges vom normalen Sputterbereich, bei dem die Leistungsaufnahme der Kathode durch eine flächenhafte Erweiterung des Sputterbereiches (Tracks) von statten geht, zum anormalen Sputtermodus, bei dem die Leistungssteigerung durch die Erhöhung des negativen Kathodenpotentials geschieht, für breite und schmale freie Trackbreiten der erfindungsgemäßen Hochdruck-Magnetronkathode gezeigt. Dimensionierungen und Werte hängen stark von der Auslegung und Größe der gewählten Kathode ab.

In der Figur 2 ist eine schematische Darstellung einer quasi-off-axis Deposition gezeigt, die mit Hilfe einer Blendenanordnung ermöglicht wird. Die Pfeile deuten dabei die Depositionsrichtung an, die stark von der Normalen zur Targetoberfläche abweicht.
Die Bezugszeichen bedeuten: 1: Substrat; 2: Plasma; 3: Target; 4: Blenden
Üblicherweise wird eine off-axis Geometrie durch Verdrehung des Substrates um 90° erreicht. Diese bekannte Geometrie weist jedoch Nachteile hinsichtlich ihrer Homogenität auf, die durch die Anordnung gemäß Figur 2 vermieden werden.

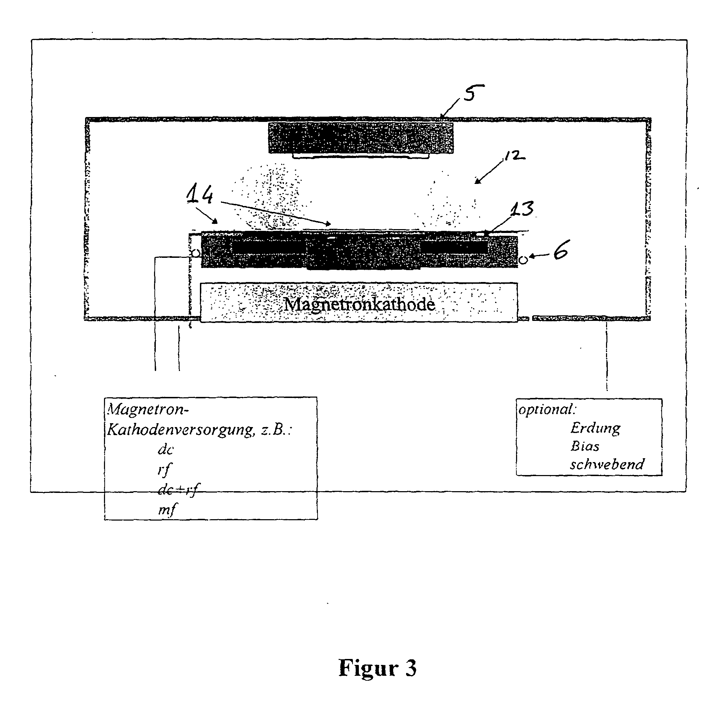

In der Figur 3 ist die erfindungsgemäße Hochdruck-Magnetron-Kathode dargestellt.

Im einzelnen ist in der Figur 3 eine schematische Gesamtdarstellung des Kathodensystems mit Blendenanordnung 14 gezeigt, bestehend aus innerer und äußerer Blende und Strahlungsschildern, einer quasi-off-axis Konfiguration mit paralleler Anordnung von Target- und Substratoberfläche, der Reduktion der freien Trackbreite, auf die das im Bild angedeutete Plasma 12 beschränkt ist, und integrierten Gasduschen 6.
Weitere Bezugszeichen bedeuten: 5: Substratheizer; 13: Target.

## Patentansprüche

1. Magnetron-Kathode mit einer eine oder mehrere Blenden enthaltenden Blendenanordnung (14) am Rand des kathodenseitigen Dunkelraums der Gasentladung, **gekennzeichnet durch** ein oder mehrere in der Blendenanordnung enthaltene Strahlungsschilder.

2. Magnetron-Kathode nach vorhergehendem Anspruch, **gekennzeichnet durch** eine Blendenanordnung (14), die elektrisch geerdet, schwebend oder mit Biasspannung versorgt ist.

3. Magnetron-Kathode nach einem der vorhergehenden Ansprüche, **dadurch gekennzeichnet, daß** die Blendenanordnung (14) so ausgebildet ist, daß auch innenliegende Targetmaterial-freie Bereiche abgeblendet sind und das Target (3, 13) ringförmig ausgebildet ist.

4. Magnetron-Kathode nach einem der vorhergehenden Ansprüche, **gekennzeichnet durch** ein hochtemperatursupraleitendes Material zur Ausbildung des Targets (3, 13).

5. Magnetron-Kathode nach einem der vorhergehenden Ansprüche, **gekennzeichnet durch** eine oder mehrere in die Blendenanordnung integrierte Gasduschen (6).

6. Vorrichtung mit wenigstens einer Magnetron-Kathode nach einem der vorhergehenden Ansprüche.

7. Vorrichtung mit wenigstens einer Magnetron-Kathode nach einem der vorhergehenden Ansprüche, **gekennzeichnet durch** freie Tracks.

## Claims

1. Magnetron cathode comprising a diaphragm arrangement (14) including one or more diaphragms at the edge of the cathode dark area of the gas discharge, **characterised by** one or more radiation shields within the diaphragm arrangement.

2. Magnetron cathode according to the above claim, **characterised by** a diaphragm arrangement (14) which is electrically earthed, floating or fed a bias voltage.

3. Magnetron cathode according to one of the above claims, **characterised in that** the diaphragm arrangement (14) is such that even internally placed areas which are free of target material are screened and the target (3, 13) is of circular design.

4. Magnetron cathode according to one of the above claims, **characterised by** a high-temperature super-conductive material for establishing the target (3, 13).

5. Magnetron cathode according to one of the above claims, **characterised by** one or more gas showers (6) which are integrated with the diaphragm arrangement.

6. Device with at least one magnetron cathode according to one of the above claims.

7. Device with at least one magnetron cathode according to one of the above claims, **characterised by** free tracks.

## Revendications

1. Cathode au magnétron avec un dispositif à diaphragmes (14) contenant un ou plusieurs diaphragmes située à la périphérie de l'espace sombre côté cathode de la décharge gazeuse, **caractérisée par** une ou plusieurs plaques de rayonnement incluses dans le dispositif à diaphragmes.

2. Cathode au magnétron selon la revendication précédente, **caractérisée par** un dispositif à diaphragmes (14), qui est mis électriquement à la terre, flottant ou alimenté avec une tension de polarisation de grille.

3. Cathode au magnétron selon l'une quelconque des revendications précédentes, **caractérisée en ce que** le dispositif à diaphragmes (14) est conçu de façon que des zones intérieures et dépourvues de matériau cible sont diaphragmées et la cible (3, 13) est conçue avec une forme annulaire.

4. Cathode au magnétron selon l'une quelconque des revendications précédentes, **caractérisée par** un matériau supraconducteur à températures élevées pour la formation de la cible (3, 13).

5. Cathode au magnétron selon l'une quelconque des revendications précédentes, **caractérisée par** une ou plusieurs douches à gaz (6) intégrées dans le dispositif à diaphragmes.

6. Dispositif avec au moins une cathode au magnétron selon l'une quelconque des revendications précédentes.

7. Dispositif avec au moins une cathode au magnétron selon l'une quelconque des revendications précédentes, **caractérisé par** des pistes libres.
